(19) Europäisches Patentamt
European Patent Office
Office européen des brevets

(11) **EP 4 557 339 A1**

(12) **EUROPEAN PATENT APPLICATION**
published in accordance with Art. 153(4) EPC

(43) Date of publication:
**21.05.2025 Bulletin 2025/21**

(21) Application number: **23839706.1**

(22) Date of filing: **14.07.2023**

(51) International Patent Classification (IPC):
**H01G 9/20** $^{(2006.01)}$ **H01L 31/043** $^{(2014.01)}$

(52) Cooperative Patent Classification (CPC):
**H01G 9/20; H10F 19/40; Y02B 10/10; Y02E 10/50**

(86) International application number:
**PCT/JP2023/026073**

(87) International publication number:
**WO 2024/014537 (18.01.2024 Gazette 2024/03)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **14.07.2022 JP 2022113373**

(71) Applicant: **International Frontier Technology Laboratory, Inc.**
**Tokyo 105-0001 (JP)**

(72) Inventors:
• **KOMATSU, Nobuaki**
**Tokyo 105-0001 (JP)**
• **ITO, Tomoko**
**Tokyo 105-0001 (JP)**

(74) Representative: **Ter Meer Steinmeister & Partner Patentanwälte mbB**
**Artur-Ladebeck-Strasse 51**
**33617 Bielefeld (DE)**

(54) **LAMINATED-TYPE PHOTOVOLTAIC BLOCK**

(57) An object of the present invention is to provide a technique of a laminated-type photovoltaic block having a laminated photovoltaic layer and having a high photovoltaic efficiency. In order to solve the above-described problems, one of representative laminated-type photovoltaic blocks according to the present invention is a block body in which flat plate-shaped photovoltaic cells are laminated, in which a height dimension of the block body is the same as or more than a dimension of any one of a depth dimension or a width dimension. Alternatively, a laminated-type photovoltaic block that is a block body in which at least five or more flat plate-shaped photovoltaic cells are laminated, in which end surfaces of the laminated photovoltaic cells are aligned in a substantially flat surface shape is also able to be used. Further, a window/-exterior material in which the laminated-type photovoltaic blocks are surrounded by using a frame is able to be used.

FIG. 1A

10

EP 4 557 339 A1

## Description

Technical Field

The present invention relates to a laminated-type photovoltaic block.

Background Art

In a situation where the movement toward a sustainable society is rapidly increasing, it is required to reduce environmental load such as energy saving and $CO_2$ reduction for structures such as houses and buildings. In the meantime, a technique development for installing solar cells on a roof, a window, and the like of a building structure and performing the power generation by light has been progressing.

For example, Patent Document 1 discloses "a solar cell module including, in the following order, a glass plate located on a light-receiving surface side, a solar cell, and a glass plate located on a rear surface side, in which a low radiation film is formed on a surface of at least one of the light-receiving surface side and the rear surface side".

In addition, Patent Document 2 discloses a solar cell window panel that is able to change a solar heat acquisition rate without performing a mechanical operation. Accordingly, "a solar cell window glass 10 is disposed in an opening portion of a building. A configuration in which the solar cell window glass 10 includes a glass panel 12 having translucency and a plurality of solar cell modules 14 alternately disposed on an indoor side surface 12a and an outdoor side surface 12b of the glass panel 12 in a height direction" is disclosed.

Citation List

Patent Documents

Patent Document 1: Japanese Patent Application Laid-Open No. 2021-15939
Patent Document 2: Japanese Patent Application Laid-Open No. 2021-11809

Summary of the Invention

Problem to be Solved by the Invention

However, both Patent Document 1 and Patent Document 2 assume that the light-receiving surface of the solar cell is disposed at an angle as close to perpendicular as possible to a light incidence angle. In addition, Patent Document 2 discloses a structure in which a solar cell is laminated on an N layer, but in the window glass with the solar cell in Patent Document 2, an opening ratio by a solar cell module disposed in a plurality of layers is 0% at the solar noon altitude on the summer solstice and 40% or more at the solar noon altitude on the winter solstice. Therefore, the solar cell module of Patent Document 2 has a large restriction on an area of disposition, and has a problem in power generation efficiency due to the solar cell.

Therefore, an object of the present invention is to provide a laminated-type photovoltaic block technique having a laminated photovoltaic layer and having a high photovoltaic efficiency.

Means for solving the Problems

In order to solve the above-described problems, one of the representative laminated-type photovoltaic blocks according to the present invention is a block body in which flat plate-shaped photovoltaic cells are laminated, in which a height dimension of the block body is the same as or more than a dimension of any one of a depth dimension or a width dimension.

Advantageous Effect of the Invention

According to the present invention, it is possible to provide a laminated-type photovoltaic block technique having a laminated photovoltaic layer and having a high photovoltaic efficiency.

The problems, configurations, and effects other than those described above are clarified by the description in Modes for carrying out the Invention.

Brief Description of the Drawings

FIG. 1A is a schematic view of a laminated-type photovoltaic block.
FIG. 1B is a top view of the laminated-type photovoltaic block.
FIG. 1C is a side view of the laminated-type photovoltaic block.
FIG. 2A is a cross-sectional view of a configuration example of a photovoltaic cell.
FIG. 2B is a cross-sectional view of a configuration example of the photovoltaic cell.
FIG. 2C is a cross-sectional view of a configuration example of the photovoltaic cell.
FIG. 2D is a cross-sectional view of a configuration example of the photovoltaic cell.
FIG. 3 is a view describing a relationship of a light-receiving angle with respect to a single photovoltaic cell.
FIG. 4 is a view describing a relationship of a light-receiving angle with respect to the laminated-type photovoltaic block.
FIG. 5 is a graph illustrating an obliquely incident light characteristics (cosine characteristics) of the illuminance.
FIG. 6 is a graph illustrating a relationship between the obliquely incident light characteristics and a conversion efficiency.
FIG. 7A is a top view describing a photovoltaic cell according to a second embodiment.
FIG. 7B is a cross-sectional view describing the photovoltaic cell according to the second embodiment.
FIG. 7C is a cross-sectional view describing the laminated-type photovoltaic block according to the second embodiment.
FIG. 8A is a schematic view of a frame that accommodates the laminated-type photovoltaic block.
FIG. 8B is a view describing a step of accommodating the photovoltaic cell in the frame.
FIG. 8C is a schematic view of a window member and an exterior material accommodated in the frame.
FIG. 9 is a schematic cross-sectional view of an extraction electrode of the laminated-type photovoltaic block.

Modes for carrying out the Invention

Hereinafter, embodiments of the present invention will be described with reference to the drawings. The present invention is not limited to this embodiment. In addition, in the description of the drawings, the same portions are denoted by the same reference numerals.

In the present disclosure, the "window/exterior member" means all members having translucency that partition a window installed in a building or a structure, all members having translucency that partition an internal space of a building or a structure, all members having translucency that partition the inside and outside or the like of a vehicle body of an automobile, all members that constitute a roof or a wall surface of a building or a structure, and various forms not only a member that is in contact with outside air and is used as an outermost layer of a building or a structure but also a member used as an inner layer.

In addition, the laminated-type photovoltaic block body according to the present disclosure is able to be used as a window member, an exterior material, or other members by combining the laminated-type photovoltaic block with a frame or the like.

In addition, the laminated-type photovoltaic block of the present disclosure is able to be used for various applications such as an object, a power generation device, and a charging device.

[First Embodiment]

<Laminated-type Photovoltaic Block Body>

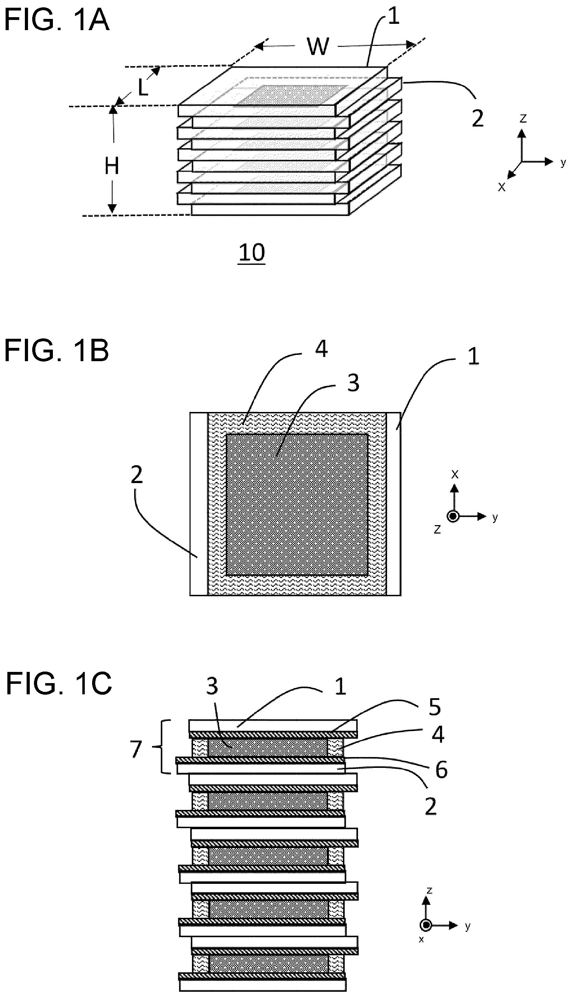

Hereinafter, a first embodiment of a laminated-type photovoltaic block according to the present disclosure will be described with reference to FIGS. 1A to 1C.

FIG. 1A is a schematic view of the laminated-type photovoltaic block. In FIG. 1A, in a laminated-type photovoltaic block 10, a plurality of layers of photovoltaic cells configured of an upper transparent substrate 1, a lower transparent substrate 2, and a power generation unit sandwiched between the two transparent substrates, and the like are laminated. In addition, in a case where a dimension of the laminated-type photovoltaic block 10 in a z direction is denoted by H, a dimension of the laminated-type photovoltaic block 10 in an x direction is denoted by L, and a dimension of the laminated-type photovoltaic block 10 in a y direction is denoted by W, the photovoltaic cells are in a laminated state to such an extent that H is the same as or more than a dimension of any one of L and W.

That is, in a case where the dimension in the z direction is a height, the dimension in the x direction is a depth, and the dimension in the y direction is a width, the height is the same as or more than the dimension any one of the depth or the width.

In the present disclosure, hereinafter, a "height direction" may be referred to as a "lamination direction". In addition, a +z direction may be referred to as an upper direction, and a -z direction may be referred to as a lower direction.

In the example illustrated in FIG. 1A, a block body is obtained by laminating five layers of flat plate-shaped photovoltaic cells, but it is desirable that the number of laminations is five layers or more.

The photovoltaic cell does not necessarily have to be a flat plate, and may have a plate shape having a curved surface. In addition, the upper transparent substrate 1 and the lower transparent substrate 2 may be made of a translucent material such as glass or acrylic.

Next, a planar structure of the laminated-type photovoltaic block 10 will be described with reference to FIG. 1B. FIG. 1B is a top view of the laminated-type photovoltaic block, in which the upper transparent substrate 1 and the lower transparent substrate 2 are disposed to be shifted in the y direction, and a photovoltaic region 3 and a sealing portion 4 for sealing the photovoltaic region 3 are disposed in a region where the upper transparent substrate 1 and the lower transparent substrate 2 overlap each other in the z direction. The sealing portion 4 is disposed such that the photovoltaic region is surrounded.

The photovoltaic region 3 and the sealing portion 4 do not necessarily have to coincide with the region where the upper transparent substrate 1 and the lower transparent substrate 2 overlap each other in the z direction. The photovoltaic region 3 and the sealing portion 4 may be present inside the region where the upper transparent substrate 1 and the lower transparent substrate 2 overlap each other in the z direction.

In the photovoltaic cell illustrated in FIG. 1B, an example in which the photovoltaic region 3 has a light brown color is described, but the photovoltaic region 3 does not necessarily have a color and may be transparent. It is desirable that the other members are formed of a substantially transparent material.

Next, a cross-sectional structure of the laminated-type photovoltaic block 10 will be described with reference to FIG. 1C. FIG. 1C is a side view schematically illustrating a cross-sectional structure of the laminated-type photovoltaic block.

An upper electrode 5 and a lower electrode 6 are disposed on sides of the surfaces of the upper transparent substrate 1 and the lower transparent substrate 2, respectively, which are in contact with the photovoltaic region 3. The upper electrode 5 and the lower electrode 6 may be transparent conductive films such as FTO and ITO formed on the surfaces of the upper transparent substrate 1 and the lower transparent substrate 2, respectively.

In one photovoltaic cell 7, the upper transparent substrate 1 and the lower transparent substrate 2 are disposed to be shifted in the y direction, so that the upper electrode 5 and the lower electrode 6 are able to be connected from the outside. Power generated in the photovoltaic cell is able to be extracted to the outside through portions of the upper electrode 5 and the lower electrode 6 that are able to be connected to the outside.


(Variation of Photovoltaic Cell)

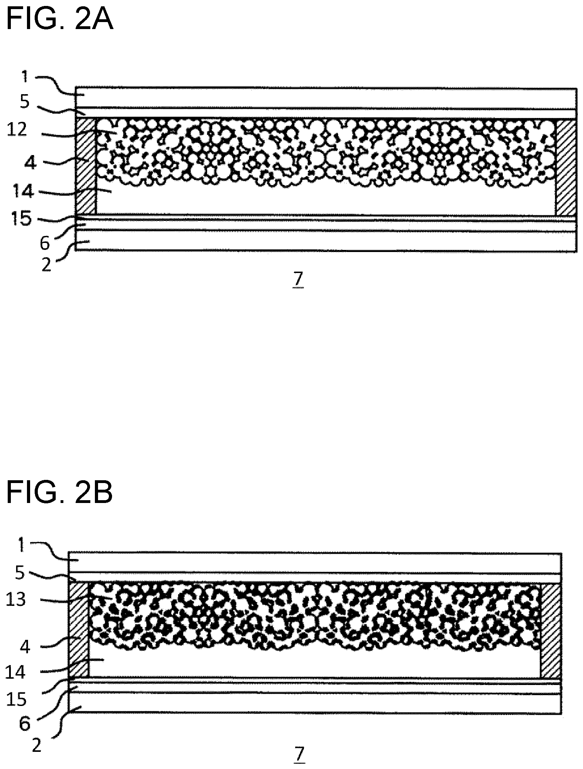

Next, some examples of the configuration of the photovoltaic cell 7 will be described with reference to FIGS. 2A to 2D. As the photovoltaic cell that is able to be used in the present invention, any form of photovoltaic cell, photovoltaic element, or solar cell is able to be used as long as it is able to surround the photovoltaic region with a translucent substrate.

Hereinafter, examples of the photovoltaic cell will be described with reference to FIGS. 2A to 2D, but these examples do not limit the applicability of the technique of the present disclosure.

The photovoltaic cell 7 illustrated in FIG. 2A to FIG. 2D is a cross-sectional view of the photovoltaic cell 7 constituting the laminated-type photovoltaic block illustrated in FIG. 1A, in an xz plane.

The photovoltaic cell of FIG. 2A is a wet photovoltaic element using a titanium dioxide layer as a photovoltaic layer.

In FIG. 2A, the upper transparent substrate 1 is a transparent substrate configured of glass or a resin, and the upper electrode 5 formed of a transparent conductive film such as FTO is formed on one surface thereof.

In addition, the lower electrode 6 and a charge exchange layer 15 are disposed above the lower transparent substrate 2, and a porous titanium dioxide 12 as the photovoltaic layer is disposed below the upper electrode 5.

An electrolyte 14 is sealed between the upper electrode 5 and the lower electrode 6. In this electrolyte, an iodine-based electrolyte in which iodine is dissolved in a potassium iodide aqueous solution is generally used.

In addition, the sealing portion 4 is in close contact with the upper and lower transparent substrates so that the electrolyte 14 does not flow out to the outside.

The photovoltaic cell of FIG. 2B is different from that of FIG. 2A in that a dye-sensitized porous titanium dioxide 13 in which a sensitizing dye such as a ruthenium complex dye is solidified is adopted as the photovoltaic region. That is, the photovoltaic cell of FIG. 2B is a general Dye Sensitized Solar Cell (DSSC). Since other configurations are the same as those in FIG. 2A, the same or equivalent components as those in FIG. 2A are denoted by the same reference numerals, and the description thereof will be simplified or omitted.

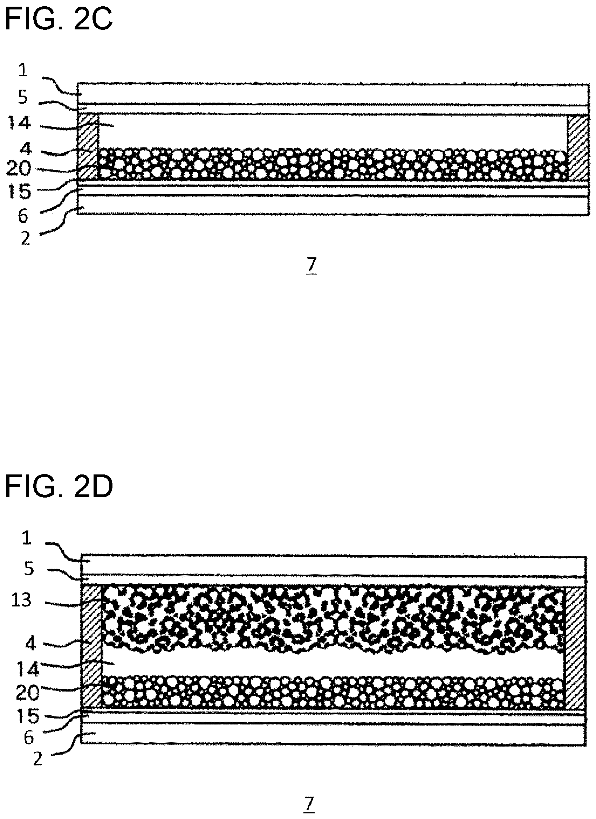

Next, the photovoltaic cell of FIG. 2C is different from the photovoltaic cell of FIG. 2B in that, as the photovoltaic

EP 4 557 339 A1

layer, silicon dioxide particles 20 having a particle diameter of 500 nm or less are adopted without using the porous titanium dioxide, and the silicon dioxide particles 20 are mixed with ethanol and applied onto the charge exchange layer 15 configured of platinum or the like and dried.

Since other configurations are the same as those in FIG. 2A, the same or equivalent components as those in FIG. 2A are denoted by the same reference numerals, and the description thereof will be simplified or omitted.

Next, the photovoltaic cell of FIG. 2D is different from those of FIGS. 2A to 2C in that two layers of a layer of a dye-sensitized porous titanium dioxide 13 and a layer of silicon dioxide particles 20 are used as the photovoltaic layer. Since other configurations are the same as those in FIG. 2A, the same or equivalent components as those in FIG. 2A are denoted by the same reference numerals, and the description thereof will be simplified or omitted.

As described above, various photovoltaic elements are able to be adopted in the photovoltaic cell 7 according to the present disclosure. In particular, a photovoltaic element in which silicon dioxide is provided in a photovoltaic layer, which is disclosed in Japanese Patent No. 5848324 or the like, is suitable, but the present invention is not necessarily limited thereto.

(Photovoltaic Characteristics)

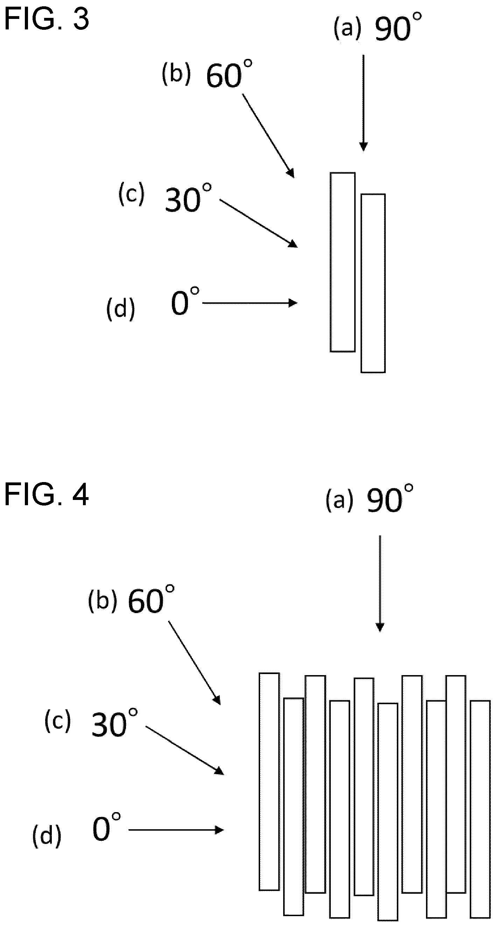

Next, angle characteristics of the photovoltaic characteristics of the laminated-type photovoltaic block in which five layers of the photovoltaic cells 7 illustrated in FIG. 1C are laminated will be described with reference to FIGS. 3 and 4 in comparison with the single photovoltaic cell 7.

FIG. 3 is a view illustrating a relationship of each of light-receiving angles with respect to the single photovoltaic cell 7 in a case where a plane direction of the light-receiving surface is 90° and a normal direction is 0°.

In addition, FIG. 4 is a view illustrating a relationship of each of light-receiving angles with respect to the laminated-type photovoltaic block in which five layers of the single photovoltaic cell 7 are laminated in a case where the plane direction of the light-receiving surface is 90° and the normal direction is 0°.

In both the case of FIG. 3 and the case of FIG. 4, as the photovoltaic cell 7, the dye sensitized solar cell including silicon dioxide and dye-containing titanium dioxide as the photovoltaic layer described in FIG. 2 is used. Then, in a case where the dye sensitized solar cell was irradiated with a ray of 1 sun (1,000 W/m$^2$), a maximum output illustrated in Table 1 could be obtained.

[Table 1]

| Light-receiving angle | Single cell | Five-layer laminated-type photovoltaic block |
|---|---|---|
| 90° | 220.2 | 348.35 |
| 60° | 276.91 | 470 |
| 30° | 285.17 | 621 |
| 0° | 425.9 | 654.13 |
| (Unit: $\mu$W/cm$^2$) | | |

As it is determined from the above data, in the laminated-type photovoltaic block, a considerable amount of photovoltaic ability is able to be exhibited even though light is not necessarily incident from the normal line of the light-receiving surface.

(Obliquely Incident Light Characteristics)

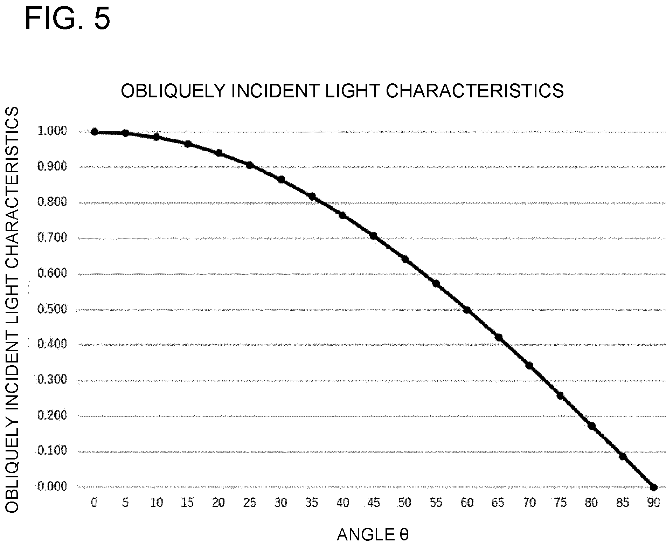

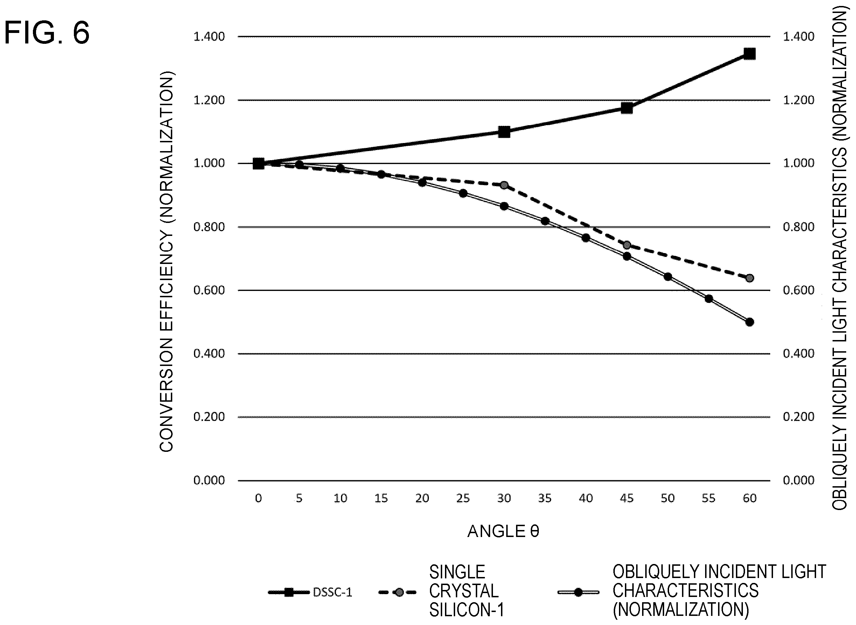

Next, regarding the photovoltaic cell of a type in which the photovoltaic region is surrounded by the translucent substrate, a relationship between the obliquely incident light characteristics (cosine characteristics) of the illuminance, the obliquely incident light characteristics, and the conversion efficiency will be described with reference to FIGS. 5 and 6.

FIG. 5 is a graph illustrating the obliquely incident light characteristics (cosine characteristics) of the illuminance. The illuminance on the light-receiving surface of the photovoltaic element changes in proportion to $\cos\theta$ of the incidence angle $\theta$ of the light incident on the light-receiving surface, and the illuminance (E2) when the light-receiving surface is illuminated in an oblique $\theta$ direction is $\cos\theta$ times the illuminance (E1) when the light-receiving surface is illuminated in the normal direction. Therefore, the incident light characteristics at each angle in a case where the normal direction ($\theta = 0°$) of the light-receiving surface is set to "1" are as illustrated in the graph of FIG. 5.

5

(Conversion Efficiency of Obliquely Incident Light)

Next, a relationship between the obliquely incident light characteristics and the conversion efficiency will be described with reference to FIG. 6. FIG. 6 is a graph illustrating the relationship between the obliquely incident light characteristics and the conversion efficiency. In the graph, a line indicated by a solid line (DSSC-1) indicates the conversion efficiency at each angle in a case where the normal direction ($\theta = 0°$) of the photovoltaic cell (1 sheet) of the DSSC is set to "1" using a left vertical axis.

In addition, results of measuring the same conversion efficiency characteristics with the single crystal silicon photovoltaic element are illustrated by a dotted line (single crystal silicon-1). Since the dotted line also illustrates the conversion efficiency at each angle, the dotted line is illustrated using the left vertical axis.

In the graph of FIG. 6,

the conversion efficiency $\eta$ is a value obtained by the following calculation equation.

$$\eta = Pmax \div (E \times A) \times 100$$

$\eta$: conversion efficiency [%]
Pmax: output at optimum operating point [W]
$E(E\theta)$: irradiation illuminance [W/m$^2$]
A: light-receiving area [m$^2$]

In the graph of FIG. 6, it is considered that the reason why the conversion efficiency increases with an increase in $\theta$ in the solid line (DSSC-1) is due to the influence of the wall surface reflection of the measurement environment, the light being turned around from the glass side surface, the increase in angle, the incident light from the back side surface, or the like.

In any case, it is able to be seen that, in the photovoltaic cell sandwiched by the translucent substrate, it is possible to increase the photovoltaic efficiency to a considerable extent even in a case where the light-receiving surface is not necessarily set to be perpendicular to the light incident direction.

In the photovoltaic cells of single crystal silicon, amorphous silicon, and the like in the related art, it is necessary to set the light-receiving surface in a direction in which sunlight is incident. However, in the photovoltaic element including the photovoltaic region sandwiched between the translucent substrates, as described in the present disclosure, it is possible to realize a high photovoltaic efficiency even with the laminated-type photovoltaic block in which a plurality of translucent substrates are laminated.

[Second Embodiment]

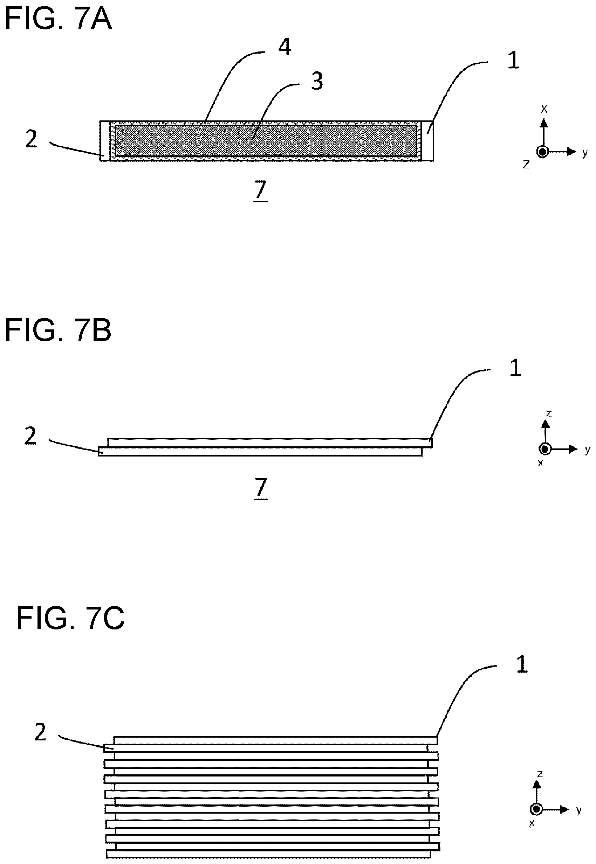

Next, a second embodiment will be described with reference to FIGS. 7A to 7C, based on the fact that the dependence of the photovoltaic ability of the laminated-type photovoltaic block on the incidence angle is small.

The second embodiment is different from the first embodiment in that the photovoltaic cell has an elongated shape. FIG. 7A is a top view of the photovoltaic cell as viewed from the z direction, and FIG. 7B is a schematic cross-sectional view of the photovoltaic cell in an yz plane. FIG. 7C is a schematic cross-sectional view of the laminated-type photovoltaic block in the yz plane in the second embodiment.

In the following description, the same or equivalent components as those in the first embodiment described above are denoted by the same reference numerals, and the description thereof will be simplified or omitted.

In the laminated-type photovoltaic block according to the second embodiment, by setting the photovoltaic cell in an elongated shape, a large area is able to be obtained in the yz plane as illustrated in FIG. 7C when the laminated-type photovoltaic block is formed. In addition, in the area of the yz plane, most of the area is occupied by the upper transparent substrate and the lower transparent substrate, and thus the entire laminated-type photovoltaic block is a block having a substantially transparent surface when being viewed from the x-axis direction.

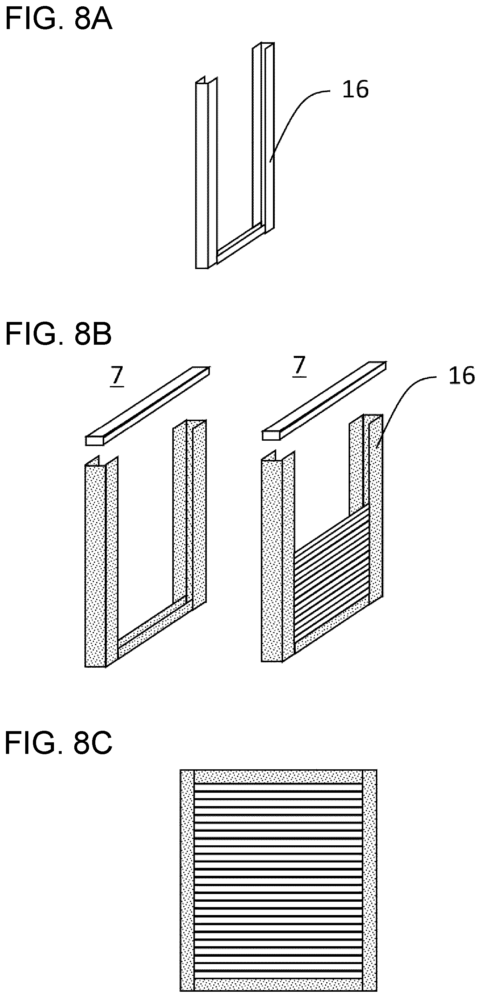

Next, an example of a case where the laminated-type photovoltaic block according to the second embodiment is used as a window member or an exterior material will be described with reference to FIGS. 8A to 8C.

FIG. 8A is a schematic view of a frame 16 for accommodating the laminated-type photovoltaic block by being fixed as a member having a certain size. The frame 16 is able to be created as the frame 16 having a sash structure using a metal such as aluminum so that the laminated-type photovoltaic block is able to be accommodated inside the frame 16.

As illustrated in FIG. 8B, by sequentially inserting the elongated photovoltaic cell 7 into such a frame 16, it is possible to obtain a window member or an exterior material having a photovoltaic ability, in which a periphery is surrounded by the frame made of aluminum or the like and the entire surface is formed of a transparent conductive substrate made of glass or the like, as illustrated in FIG. 8C.

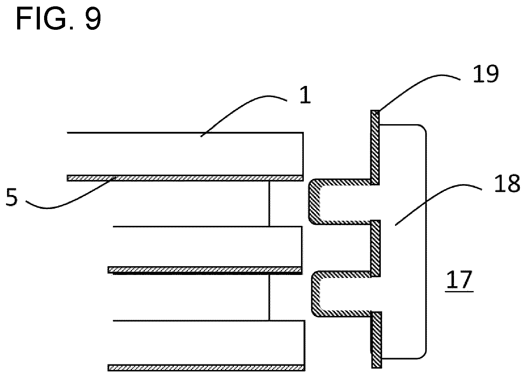

Next, an example of an extraction electrode 17 for extracting power from the laminated-type photovoltaic block will be described with reference to FIG. 9. FIG. 9 is a schematic cross-sectional view of the extraction electrode installed on a side where the upper electrode 5 or the lower electrode 6 of the laminated-type photovoltaic block is exposed to the outside.

The extraction electrode 17 is formed in a shape such as engaging with the unevenness of the side surface of the laminated-type photovoltaic block in which the upper electrode 5 or the lower electrode 6 is exposed to the outside on one surface thereof, and is configured of an extraction electrode base portion 18 and an extraction electrode contact portion 19 that is in contact with the upper electrode 5 or the lower electrode 6.

The extraction electrode base portion 18 is formed of plastic, rubber, glass, or the like, and the extraction electrode contact portion 19 is subjected to a conductive processing such as silver plating so that conductivity is able to be secured.

By using such an extraction electrode, power is able to be easily extracted from the laminated-type photovoltaic block. In addition, by providing the extraction electrode 17 as a member that absorbs the uneven shape of the laminated-type photovoltaic block on the surface of the side surface of the laminated-type photovoltaic block where the unevenness is present, it is possible to eliminate the rattling of the laminated-type photovoltaic block in the frame 16 and to stably hold the laminated-type photovoltaic block in the frame.

<Actions and Effects>

In the solar cell module in the related art, the light-receiving surface of the solar cell is assumed to be disposed at an angle as close to perpendicular as possible to the light incidence angle, and thus the light from the outside to the inside is blocked.

However, in a case where the laminated-type photovoltaic block according to the present disclosure is used as the window member, since the photovoltaic region is formed in a very thin film in the horizontal direction, it is possible to achieve sufficient photovoltaic by utilizing incident light from multiple directions without blocking light from the outside to the inside.

Moreover, since the thickness of the upper and lower transparent substrates of the basic photovoltaic cell is about 1 mm and the thickness of the photovoltaic region is able to also be 1 mm or less, a laminated-type photovoltaic block having various shapes is able to be obtained by combining the photovoltaic cells.

Hereinabove, the embodiments of the present invention have been described, but the present invention is not limited to the above-described embodiments, and various changes are able to be made without departing from the scope of the present invention.

For example, the elongated-shaped photovoltaic cell described in the second embodiment includes one elongated-shaped photovoltaic portion, but may include a plurality of photovoltaic portions by dividing the elongated-shaped photovoltaic portion.

In addition, in the above-described embodiment, the shapes of the photovoltaic cell and the photovoltaic portion are described as a rectangular shape, but the shapes are not limited to the rectangular shape, and various shapes such as a circular shape, an elliptical shape, and a polygonal shape are able to be adopted. Therefore, the shape of the laminated-type photovoltaic block is not limited to a plate shape and may be a columnar shape, and various shapes are able to be adopted.

In addition, the upper and lower transparent substrates have been described as having a flat plate shape, but the transparent substrate is not limited to the flat plate and may have a curved surface.

Description of Reference Numerals

    1: upper transparent substrate
    2: lower transparent substrate
    3: photovoltaic region
    4: sealing portion
    5: upper electrode
    6: lower electrode
    7: photovoltaic cell
    10: laminated-type photovoltaic block
    12: porous titanium dioxide
    13: dye-sensitized porous titanium dioxide
    14: electrolyte

15: charge exchange layer
16: frame
17: extraction electrode
18: extraction electrode base portion
19: extraction electrode contact portion
20: silicon dioxide particle

**Claims**

1. A laminated-type photovoltaic block that is a block body in which flat plate-shaped photovoltaic cells are laminated, wherein a height dimension of the block body is the same as or more than a dimension of any one of a depth dimension or a width dimension.

2. A laminated-type photovoltaic block that is a block body in which at least five or more flat plate-shaped photovoltaic cells are laminated, wherein end surfaces of the laminated photovoltaic cells are aligned in a substantially flat surface shape.

3. The laminated-type photovoltaic block according to Claim 1 or 2, wherein the photovoltaic cell has a structure in which a photovoltaic region is sandwiched between translucent substrates.

4. A window/exterior member in which the laminated-type photovoltaic block according to Claim 1 or 2 is covered with a frame surrounding the laminated-type photovoltaic block.

5. The window/exterior member according to Claim 4, wherein an extraction electrode for extracting power from the laminated-type photovoltaic block is disposed between the laminated-type photovoltaic block and a frame parallel to a lamination direction of the laminated-type photovoltaic block.

6. The window/exterior member according to Claim 5, wherein the extraction electrode has a shape in which a surface being in contact with the laminated-type photovoltaic block engages with unevenness of a side surface of the laminated-type photovoltaic block, and a portion of the extraction electrode being in contact with the side surface of the laminated-type photovoltaic block is subjected to conductive processing.

FIG. 1A

10

FIG. 1B

FIG. 1C

## FIG. 2A

## FIG. 2B

## FIG. 2C

7

## FIG. 2D

7

FIG. 3

(a) 90°

(b) 60°

(c) 30°

(d) 0°

FIG. 4

(a) 90°

(b) 60°

(c) 30°

(d) 0°

# FIG. 5

OBLIQUELY INCIDENT LIGHT CHARACTERISTICS

EP 4 557 339 A1

FIG. 6

FIG. 7A

FIG. 7B

FIG. 7C

FIG. 8A

16

FIG. 8B

7                    7                    16

FIG. 8C

# FIG. 9

## INTERNATIONAL SEARCH REPORT

| International application No. |
| --- |
| **PCT/JP2023/026073** |

| A. | CLASSIFICATION OF SUBJECT MATTER |
| --- | --- |

*H01G 9/20*(2006.01)i; *H01L 31/043*(2014.01)i
FI:   H01G9/20 301; H01L31/04 510; H01G9/20 203Z

According to International Patent Classification (IPC) or to both national classification and IPC

| B. | FIELDS SEARCHED |
| --- | --- |

Minimum documentation searched (classification system followed by classification symbols)

H01G9/20; H01L31/043; H10K30/15; H10K30/50

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2009-152223 A (KABUSHIKI KAISHA KOBE SEIKO SHO) 09 July 2009 (2009-07-09) paragraphs [0036]-[0049], fig. 1-3 | 1 |
| Y | | 4-5 |
| A | | 2-3, 6 |
| X | JP 2000-200921 A (SAITO, Suguru) 18 July 2000 (2000-07-18) claim 1, paragraphs [0004]-[0009], fig. 1-5 | 1 |
| Y | | 4-5 |
| A | | 2-3, 6 |
| X | JP 2010-262793 A (BRIDGESTONE CORP.) 18 November 2010 (2010-11-18) paragraphs [0039]-[0046], fig. 2 | 2-3 |
| Y | | 4-5 |
| A | | 1, 6 |

✓ Further documents are listed in the continuation of Box C.     ✓ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **12 September 2023** | **26 September 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

# EP 4 557 339 A1

## INTERNATIONAL SEARCH REPORT

International application No.

**PCT/JP2023/026073**

### C. DOCUMENTS CONSIDERED TO BE RELEVANT

| Category* | Citation of document, with indication, where appropriate, of the relevant passages | Relevant to claim No. |
|---|---|---|
| X | JP 2008-130547 A (ELECTRONICS AND TELECOMMUNICATIONS RESEARCH INSTITUTE) 05 June 2008 (2008-06-05) paragraphs [0026]-[0037], fig. 1 | 2-3 |
| Y | | 4-5 |
| A | | 1, 6 |
| X | WO 2015/029415 A1 (NIPPON ZEON CO.) 05 March 2015 (2015-03-05) paragraphs [0016]-[0020], [0072], fig. 1-4 | 2-3 |
| Y | | 4-5 |
| A | | 1, 6 |
| Y | JP 2014-165061 A (ROHM CO., LTD.) 08 September 2014 (2014-09-08) paragraphs [0183]-[0188], fig. 51 | 4-5 |

Form PCT/ISA/210 (second sheet) (January 2015)

19

**INTERNATIONAL SEARCH REPORT**
Information on patent family members

International application No.

**PCT/JP2023/026073**

| Patent document cited in search report | | | Publication date (day/month/year) | Patent family member(s) | Publication date (day/month/year) |
|---|---|---|---|---|---|
| JP | 2009-152223 | A | 09 July 2009 | (Family: none) | |
| JP | 2000-200921 | A | 18 July 2000 | (Family: none) | |
| JP | 2010-262793 | A | 18 November 2010 | US 2012/0118375 A1<br>paragraphs [0051]-[0056], fig. 2<br>EP 2426781 A1<br>KR 10-2012-0003011 A<br>CN 102460822 A | |
| JP | 2008-130547 | A | 05 June 2008 | US 2008/0115824 A1<br>paragraphs [0034]-[0046], fig. 1<br>EP 1926111 A2<br>KR 10-2008-0046026 A | |
| WO | 2015/029415 | A1 | 05 March 2015 | US 2016/0196928 A1<br>paragraphs [0028]-[0035], [0141]-[0145], fig. 1-4<br>EP 3041009 A1<br>CN 105474338 A<br>KR 10-2016-0048069 A | |
| JP | 2014-165061 | A | 08 September 2014 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021015939 A
- JP 2021011809 A

- JP 5848324 B